**Europäisches Patentamt**

**European Patent Office**

**Office européen des brevets**

(19)

(11) Veröffentlichungsnummer: **0 027 497**
**B1**

(12) # EUROPÄISCHE PATENTSCHRIFT

(45) Veröffentlichungstag der Patentschrift:
**10.10.84**

(21) Anmeldenummer: **80103603.9**

(22) Anmeldetag: **26.06.80**

(51) Int. Cl.³: **H 01 J 37/20, H 01 J 37/304**

(54) Projektionssystem für Korpuskularstrahlen.

(30) Priorität: **27.09.79 DE 2939044**

(43) Veröffentlichungstag der Anmeldung:
**29.04.81 Patentblatt 81/17**

(45) Bekanntmachung des Hinweises auf die Patenterteilung:
**10.10.84 Patentblatt 84/41**

(84) Benannte Vertragsstaaten:
**AT DE FR GB**

(56) Entgegenhaltungen:
EP - A - 0 001 042
EP - A - 0 009 562
DE - A - 2 651 430
DE - A - 2 719 800
DE - B - 2 046 332
US - A - 3 849 659
US - A - 3 984 680

SOLID STATE TECHNOLOGY, Band 17, Nr. 7, Juli 1974,
PORT WASHINGTON, N.Y. (US) W.R. LIVESAY:
"Computer Controlled Electron-Beam Projection Mask
Aligner", Seiten 21-26

(73) Patentinhaber: **International Business Machines
Corporation, Old Orchard Road, Armonk, N.Y. 10504 (US)**

(84) Benannte Vertragsstaaten: **FR GB AT**

(73) Patentinhaber: **IBM DEUTSCHLAND GMBH,
Pascalstrasse 100, D-7000 Stuttgart 80 (DE)**

(84) Benannte Vertragsstaaten: **DE**

(72) Erfinder: **Bohlen, Harald, Geleener Strasse 26,
D-7030 Böblingen (DE)**
Erfinder: **Greschner, Johann, Dr., Zollernstrasse 14,
D-7401 Pliezhausen (DE)**
Erfinder: **Kulcke, Werner, Dr., Westerwaldweg 8,
D-7030 Böblingen (DE)**
Erfinder: **Nehmiz, Peter, Dr., Karl-Weller-Strasse 2,
D-7000 Stuttgart 80 (DE)**

(74) Vertreter: **Teufel, Fritz, Dipl.-Phys., Schönaicher
Strasse 220, D-7030 Böblingen (DE)**

**Beschreibung**

Die Erfindung betrifft ein Projektionssystem für Korpuskularstrahlen nach dem Oberbegriff des Hauptanspruchs; ein derartiges Projektionssystem ist aus der deutschen Patentanmeldung DE-A-2 719 800 bekannt.

Die Entwicklung integrierter Schaltungen in Halbleitertechnologie geht zu immer kleineren Strukturen, um damit die Dichte der Schaltkreise und deren Schaltgeschwindigkeit zu erhöhen. Die heute noch überwiegend gebräuchliche Photolithographie stößt dabei mehr und mehr an die Grenzen ihrer durch die physikalische Auflösung optischer Systeme gegebenen Möglichkeiten. Strukturen, z. B. Leiterzüge, im Submikronbereich können damit nicht mehr hergestellt werden. Die aussichtsreichsten Kandidaten zur Herstellung derartig feiner Strukturen sind Korpuskularstrahlverfahren. Die folgende Beschreibung bezieht sich auf Elektronenstrahlen; sie gilt aber sinngemäß auch für Ionenstrahlen.

Elektronenstrahlen weisen für diese Anwendung eine Reihe von Vorteilen auf; die Auflösung der mit ihnen hergestellten Muster ist nicht durch Beugungseffekte begrenzt, sie können mit hohen Intensitäten erzeugt werden und lassen sich relativ einfach und doch genau gesteuert ablenken.

Die bisher am weitesten entwickelten Verfahren arbeiten nach dem Rasterprinzip: Der Elektronenstrahl dient als sehr feiner »Griffel«, mit dem das zu belichtende Muster direkt auf das mit einer für Elektronenstrahlen empfindlichen Schicht überzogene Halbleitersubstrat geschrieben wird. Das zu erzeugende Muster ist dabei im Speicher eines Rechners enthalten, der die Ablenkung des Elektronenstrahls steuert. Die hohe Flexibilität dieser Art der Mustererzeugung wird jedoch durch einen hohen Zeitaufwand beim Schreiben erkauft. Der Durchsatz an belichteten Wafern in der industriellen Produktion ist daher gering.

Bei der Herstellung von Schaltkreisen und Schaltkreisplättchen (Chips) mit einer Vielzahl von sich wiederholenden Schaltelementen, z. B. Speicherchips, ist die Flexibilität des Rasterverfahrens von untergeordneter Bedeutung. Andererseits ist zur Reduzierung der Kosten ein hoher Durchsatz an Chips erforderlich. Die analog zu optischen photolithographischen Verfahren arbeitenden Elektronenstrahlprojektionsverfahren bieten diesen hohen Durchsatz, da bei ihnen größere Musterbereiche mit Hilfe einer Maske durch Bestrahlung mit Elektronen auf das Substrat abgebildet werden. Derartige Systeme sind beispielsweise in den Veröffentlichungen von H. Koops et al. in Optik 28, 5, 1968/1969, Seiten 518 bis 531, T. W. O'Keefe in Solid State Electronics, Pergamon Press, 1969, Band 12, Seiten 841 bis 848 und M. B. Heritage »Electron-Projection Micro Fabrication System«, J. Vac. Sci. Technol. Band 12, 1975, Seite 1135 bis 1138, beschrieben. Auch die deutschen Patentanmeldungen P 27 39 502.4 und 28 37 590.8 betreffen derartige Systeme.

Bei der Herstellung hochintegrierter monolithischer Schaltungen spielt jedoch nicht nur das Auflösungsvermögen des verwendeten Belichtungsverfahrens eine Rolle, sondern in ebensolchem Maße die Genauigkeit der gegenseitigen Ausrichtung von Maske und Halbleitersubstrat bei jedem der innerhalb eines Herstellprozesses erforderlichen Belichtungsschritte. Zur Erzielung einer guten Überlappung (sogenannter »Overlay«) muß das »Registrieren« sehr genau durchgeführt werden und erfordert infolgedessen viel Zeit. Unter Registrieren versteht man dabei das Erkennen von Strukturen, die bereits vor der Belichtung auf dem Wafer vorhanden sind, und das Ausrichten des abzubildenden Musters (Maske) zu der vorhandenen Struktur.

Als Muster zum Ausrichten (Richtmarken) dienen bei Elektronenstrahlverfahren entweder Marken aus einem anderen Material als das Halbleitersubstrat und/oder aber Gebiete mit besonderer geometrischer Gestalt, z. B. Kanten. Der auftreffende Elektronenstrahl löst auf diesen Gebieten Sekundärelektronen aus, deren reflektierter oder im Substrat absorbierter Teil gemessen und als Signal ausgewertet werden kann.

Zur Erzielung eines guten Signal/Rauschverhältnisses muß der an den Richtmarken auftreffende Elektronenstrahl eine möglichst hohe Stromdichte aufweisen (vgl. W. Stickel, »Method of optimizing registration signal for electron-beam microfabrication« in Journal of Vacuum Science and Technology, Bd. 15, Nr. 3, Mai/Juni 78, S. 901—905). Dieses Verfahren der Ausrichtung arbeitet daher zufriedenstellend für den Fall der Rasterverfahren. Die Projektionsverfahren arbeiten dagegen bei der Maskenbelichtung mit einem aufgeweiteten Elektronenstrahl relativ geringer Stromdichte. Die von diesem Strahl an den bisher üblichen Richtmarken ausgelösten Sekundärelektronen ergeben nur sehr kleine Registriersignale mit hohem Rauschanteil. Im Stand der Technik mußten deshalb besondere, im folgenden erwähnte Maßnahmen ergriffen werden, um trotzdem zu einer zufriedenstellenden Registrierung zu gelangen.

Eine Möglichkeit zur Verbesserung besteht in der Vielfachablenkung des Strahles über die Marke mit nachfolgender elektronischer Integration zur Verbesserung des Signal/Rauschverhältnisses; dieses Verfahren ist jedoch zeitaufwendig.

Als weitere Möglichkeit wurde vorgeschlagen, den Elektronenstrahl umzuschalten und zwar von einem Belichtungsmodus (mit geringer Stromdichte) in einen Registriermodus mit hoher Stromdichte (siehe z. B. den Artikel von Heritage oder die deutsche Patentanmeldung DE-A-2 719 800). Das Umschalten des Strahlengangs ist jedoch technisch nur schwer realisierbar, da die beiden Strahlengänge nicht immer reproduziert werden können.

Ein weiterer Vorschlag (8th International Con-

ference on Electron and Ion Beam Science and Technology, Mai 1978, S. 984, Frosien et al.) geht dahin, auf das Umschalten zu verzichten und stattdessen mechanische Blenden in den Strahlengang einzuklappen. Dadurch wird zwar die Umschaltung zwischen den beiden Betriebsarten vermieden, aber die Probleme mit der dann weiterhin geringen Stromdichte bleiben bestehen. Außerdem sind derartige mechanische Einstellungen nicht in sehr kurzen Zeiten zu bewerkstelligen.

Neben der Stromdichte im Elektronenstrahl spielen bei elektronenlithographischen Verfahren auch die Art der Aufnahme der Registriersignale und die geometrischen Verhältnisse eine ausschlaggebende Rolle. Die im Stand der Technik übliche Auswertung der an Richtmarken reflektierten Elektronen läßt sich bei Schattenwurfverfahren mit Elektronenstrahlen nicht ohne weiteres anwenden, da dort der Abstand zwischen Maske und Halbleiterscheibe nur sehr gering ist (typisch 0,5 mm); es können somit keine Detektorvorrichtungen für Elektronen dazwischen eingebaut werden, wie sie aus Systemen bekannt sind, bei denen zwischen Maske und Halbleiterscheibe elektronenoptische Abbildungsmittel liegen.

Bei der automatischen wie auch der manuellen Registrierung, muß zum schnellen Erreichen der Soll-Lage auch bekannt sein, welche Relativlage die Gegenstände in jedem Moment einnehmen und in welcher Richtung eine Verschiebung zur Erreichung der Soll-Lage erfolgen muß. In der deutschen Auslegeschrift 2 046 332 wird für den Fall einer photoelektrischen Vorrichtung dazu ein Ausrichtmuster angegeben, bei dem die Abstände zwischen je zwei Maskenöffnungen nicht konstant sind. Das Bildungsgesetz für die Abstände der Öffnungen entspricht einer arithmetischen Reihe. Zur zweidimensionalen Ausrichtung sind zwei, zueinander senkrecht angeordnete Streifen derartiger Maskenöffnungen vorgesehen. Diese Anordnung hat den Nachteil einer geringen Transparenz (Verhältnis der Fläche der Öffnungen zur Gesamtfläche), so daß bei einer Übertragung auf Elektronenstrahlbelichtungssysteme das Signal/Rauschverhältnis einen geringen Wert aufweisen würde. Außerdem sind bei dieser Anordnung zwei Detektoren erforderlich.

Die vorliegende Erfindung stellt sich daher die Aufgabe, ein Projektionssystem der eingangs genannten Art anzugeben, das eine schnelle, genaue und automatisch durchzuführende Registrierung ermöglicht.

Diese Aufgabe wird durch die im Hauptanspruch gekennzeichnete Erfindung gelöst; Ausgestaltungen der Erfindung sind in den Unteransprüchen gekennzeichnet.

In einem Ausführungsbeispiel der Erfindung wird vorgeschlagen, zur gegenseitigen Ausrichtung von Maske und Substrat speziell strukturierte Muster zu verwenden, die aus einer Vielzahl von Einzelmarken in besonderer gegenseitiger geometrischer Lage bestehen. Der breite Elektronenstrahl wird durch die Anordnung der Öffnungen im Richtmuster der Maske in eine Vielzahl von Einzelstrahlen aufgespalten, die jeweils mit den entsprechend angeordneten Richtmarken des Substrats in Wechselwirkung treten und ein Übereinstimmungssignal erzeugen können. Das Signal/Rauschverhältnis dieser Anordnung ist durch den Gesamtstrom bestimmt und somit vergleichbar mit dem eines dünnen, konzentrierten Elektronenstrahls. Zur Registrierung ist nur ein geringer Zeitaufwand erforderlich. Die nachteiligen Wirkungen der hohen Stromdichte im Rasterverfahren, z. B. Bläschenbildung im Photolack oder dessen Unlöslichwerden, treten hier nicht auf.

Bei der Vielzahl der zur Registrierung verwendeten Teilstrahlen werden mögliche Kantenungenauigkeiten der einzelnen Registriermarken auf dem Wafer herausgemittelt.

Die besondere geometrische Anordnung der einzelnen Richtmarken ermöglicht es, die Richtung einer Abweichung von der Soll-Lage zu erkennen. Der Registriervorgang kann daher beschleunigt und automatisiert werden.

Zur Aufnahme des Registriersignals stehen zwei verschiedene Verfahren zur Verfügung: Entweder wird der Strom gemessen, der im Substrat durch die dort absorbierten Elektronen hervorgerufen wird oder aber der an den Richtmarken reflektierte Elektronenstrom. Zur Messung des reflektierten Stroms werden spezielle integrierte Detektoreinrichtungen für Elektronen beschrieben; wegen geringerer Zeitkonstanten (RC-Glieder) kann die Signalauswertung der reflektierten Elektronen schneller als bei absorbierten Elektronen erfolgen.

Besonders vorteilhaft lassen sich die oben beschriebenen Registriermuster in einem zweistufigen Registrierprozeß verwenden. Mit Hilfe eines ersten Satzes von Registriermustern wird zuerst die gesamte Halbleiterscheibe (Wafer) mechanisch gegenüber der Maske ausgerichtet. Zusätzlich ist jedem Chipbereich (d. h. Bereich mit 5—10 mm Kantenfläche, in dem Schaltungen definiert werden sollen; auf einer Halbleiterscheibe befindet sich eine große Zahl derartiger, meist identischer, Chipbereiche) auf dem Wafer ein weiteres Paar von Registriermustern zugeordnet, das zur Feinjustierung (Chipregistrierung) durch elektronische Strahlneigung verwendet wird. Die für jeden Wafer einige hundert Mal erforderliche Feinjustierung kann daher sehr schnell erfolgen und trägt so zum hohen Durchsatz des Projektionsbelichtungsverfahrens unter Verwendung der speziellen Registriermuster bei.

Verschiedene Wege zur Ausführung der Erfindung werden nun anhand von Zeichnungen näher erläutert. Es zeigt

Fig. 1 das Prinzip eines Elektronenstrahlprojektionssystems,

Fig. 2 eine Belichtungsmaske mit Registriermustern,

Fig. 3 eine Richt-Maske mit Vielfachstrahlen zur Erhöhung des Signal/Rauschverhältnisses,

Fig. 4 eine Richt-Maske mit Vielfachstrahlen und Eindeutigkeit der Registrierung in x- und y-Richtung,

Fig. 5 ein Registriersignal bei Verwendung der Maske in Fig. 4,

Fig. 6 eine verbesserte Ausführung der in Fig. 4 dargestellten Maske,

Fig. 7 die Aufspaltung und Kippung des Elektronenstrahls bei der Registrierung,

Fig. 8 eine Richt-Maske zum Erkennen der Suchrichtung,

Fig. 9 Registriersignal bei Verwendung der Maske in Fig. 8,

Fig. 10 in den Teilfiguren A, B Belichtungsmasken mit verschiedenen integrierten Anordnungen von Elektronendetektoren,

Fig. 11 in den Teilfiguren A, B verschiedene Ausführungen von in die Belichtungsmaske integrierten Elektronendetektoren.

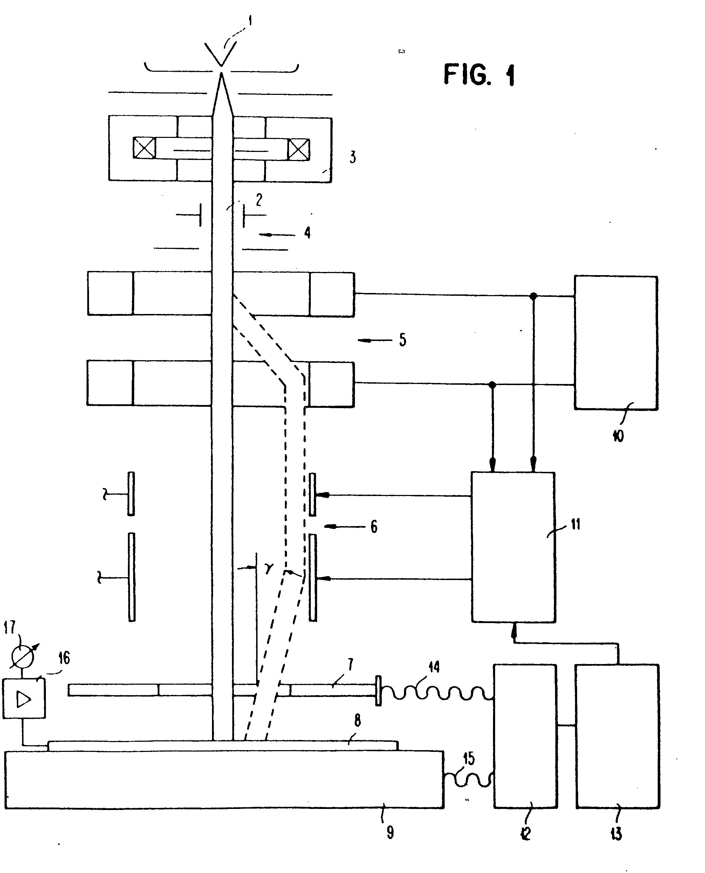

In Fig. 1 erzeugt eine Elektronenstrahlquelle 1 einen Elektronenstrahl 2, der mit einer Kollimatorlinse 3 gebündelt und mit einer Vorrichtung 4 ausgetastet werden kann. Eine elektromagnetische Ablenkvorrichtung 5 ermöglicht die steuerbare Parallelverschiebung des Elektronenstrahls, eine elektrostatische oder elektromagnetische Ablenkvorrichtung 6 ermöglicht es, den Elektronenstrahl um einen in oder in der Nähe der Maske 7 liegenden Punkt zu drehen. Ein Kreuzsupport 9 zur Aufnahme eines zu belichtenden Halbleiterplättchens (Wafer) 8, ein Rastergenerator 10 zur Strahlablenkung, ein Kippgenerator 11 zur Kippung des Strahls und eine Interferometeranordnung 12 mit interferometrischen Meßwegen 14 und 15 und gekoppelt mit einem Rechner 13 vervollständigen die Anordnung. Die interferometrische Justierung von Maske 7 und Wafer 8 ist genau in der deutschen Patentanmeldung P 2 837 590.8 beschrieben. Die einzelnen Chipbereiche werden nach der Waferregistrierung durch interferometrisch gesteuertes Verschieben des Wafers nacheinander in Belichtungsposition gebracht. Bei der (an sich sehr genauen) interferometrischen Verschiebung gelangen die Chipbereiche nur mit einer Toleranz von ungefähr 2 μ in Belichtungsposition, bedingt z. B. durch Verzerrungen des Wafers bei vorigen Heißprozeß-Schritten.

In Fig. 1 liegen zwischen Maske 7 und Wafer 8 keine weiteren elektronenoptische Abbildungsmittel. Bei einem derartigen Schattenwurfbelichtungsverfahren (Proximity Printing) erfolgt die Abbildung im Maßstab 1 : 1.

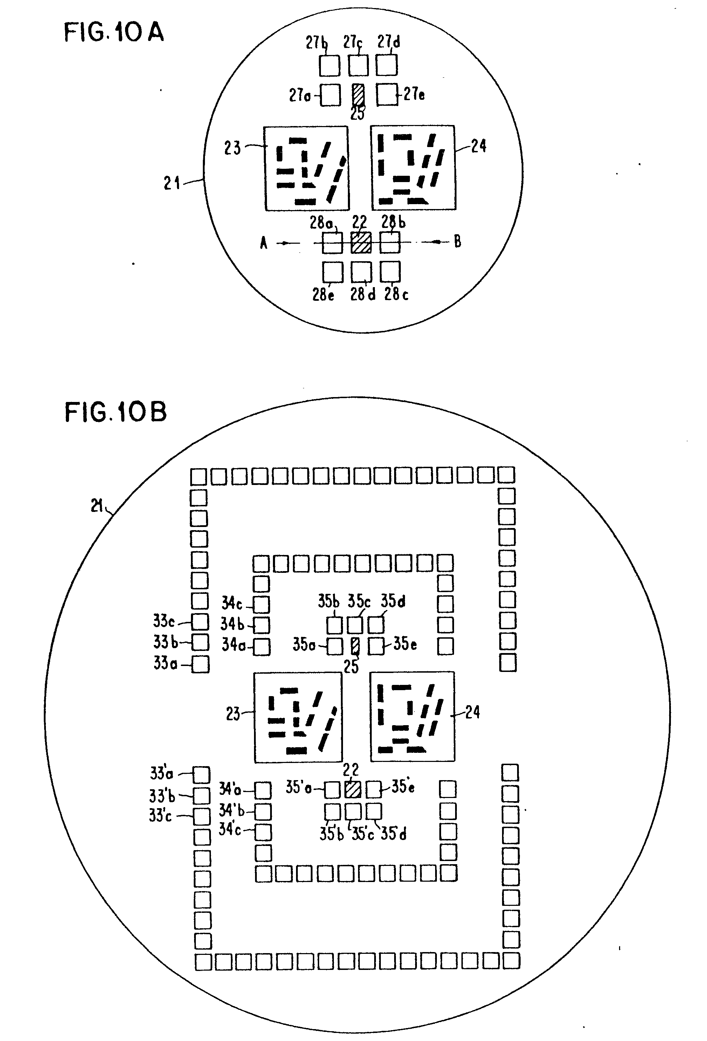

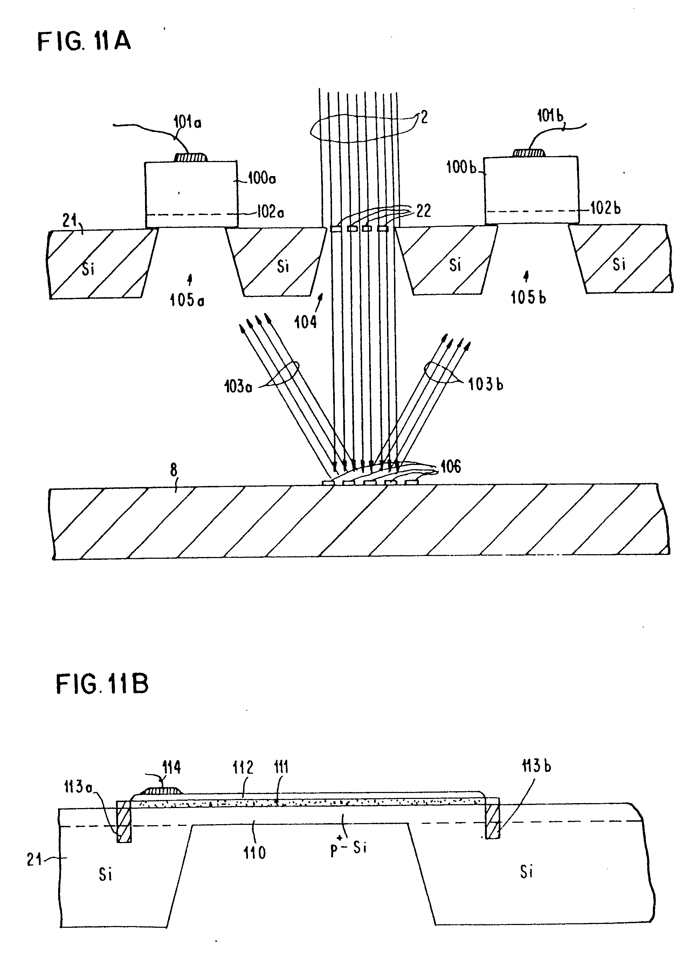

Die Maske 7 hat bei dieser Anordnung einen relativ geringen Abstand vom Wafer 8 (typisch 0,5 mm). Die im Stand der Technik übliche Messung der an Richtmarken rückgestreuten Sekundärelektronen mit Detektoren, die über dem Wafer angeordnet sind, ist aus Platzgründen nur schwer zu bewerkstelligen. Elektronendetektoren, die auch bei diesen geometrischen Verhältnissen die an den Richtmarken reflektierten Elektronen messen können, werden später anhand der Fig. 10 und 11 erläutert.

Anstelle der an Richtmarken reflektierten Elektronen können zur Registrierung auch die im Substrat absorbierten Elektronen verwendet werden. Diese beiden Signalarten und deren zeitlichen Änderungen sind einander gleichwertig.

Das im folgenden besprochene Ausführungsbeispiel bezieht sich auf den Fall der Auswertung absorbierter Elektronen. Dazu wird an den Wafer 8 eine Verstärkungseinrichtung 16 mit zugehöriger Anzeigevorrichtung 17 angeschlossen.

Neben der kompakten Bauweise hat diese Meßmethode den Vorteil, grundsätzlich auf alle absorbierten Elektronen des Registrierstrahls anzusprechen, im Gegensatz zur Messung mit Sekundärelektronen, die nur dann einen Beitrag liefern, wenn sie in den vom Detektor definierten Raumwinkel emittiert werden. Bei mit Photolack bedeckten Substraten ist der absorbierte Strom immer größer als der reflektierte, da dieser durch den Photolack geschwächt wird. Das Signal/Rauschverhältnis der absorbierten Elektronen ist außerdem besser als bei reflektierten Elektronen.

Ein Nachteil der Auswertung der absorbierten Elektronen besteht in der größeren Zeitkonstante der beteiligten Schaltkreise, die insbesondere durch die relativ große Kapazität des Substrats bestimmt ist. Diese Zeitkonstante (RC-Glieder) hängt außerdem von der Größe des Substrats ab.

Zur Registrierung wird ein zweistufiges Verfahren angewandt: mechanisch-interferometrische Waferregistrierung und schrittweises Verschieben, gefolgt von einer elektronischen Feinausrichtung durch Strahlkippung. Damit wird es möglich, auch solche Ungenauigkeiten auszugleichen, die selbst bei idealer Waferregistrierung noch auftreten, beispielsweise die durch thermische Belastung des Wafers bei den verschiedenen Heißtemperaturschritten im Herstellprozeß hervorgerufenen örtlichen Verzerrungen des Wafers (sog. Kontinentaldrift einzelner Waferbereiche). Diese unregelmäßigen Veränderungen des Wafers können eliminiert werden, wenn jeder einzelne Chipbereich von der Belichtung individuell feinjustiert wird. Da die Feinjustierung auf rein elektronischem Weg erfolgt, ist der dafür erforderliche Zeitaufwand sehr gering (etwa 100 Millisekunden).

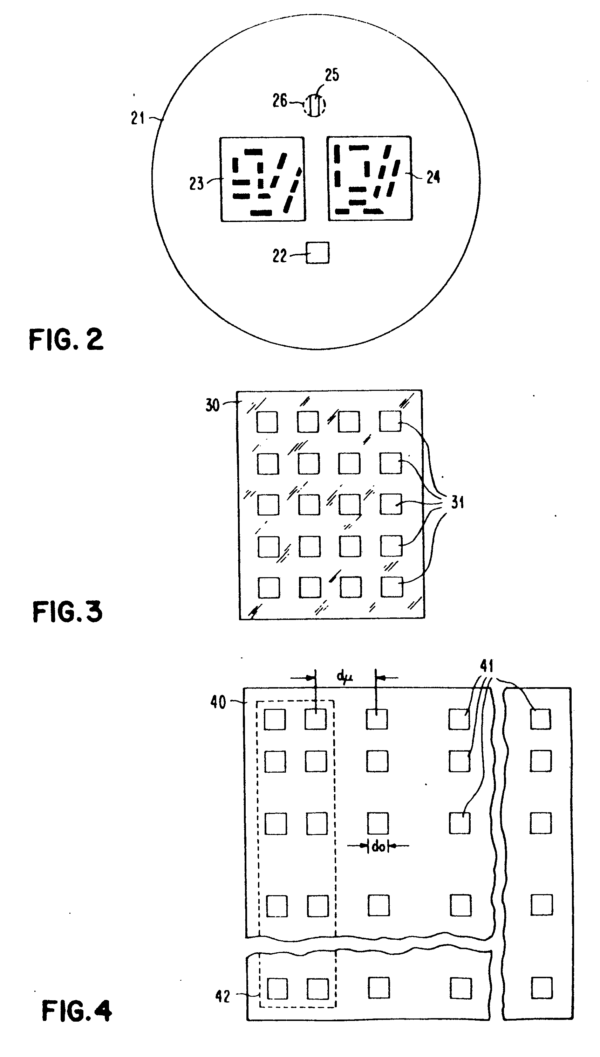

Die Anordnung der Registriermarken und Belichtungsmasken in der Schattenwurfmaske ist für den Fall eines einzelnen Chipbereichs in Fig. 2 dargestellt. Die Maskenscheibe 21 enthält eine Registriermaske 22 zum Registrieren des Wafers, eine Vielzahl von Paaren komplementärer Chipmasken 23, 24 (die genauer in der deutschen Patentanmeldung P 2 739 502.4 beschrieben sind) und für jedes Paar von Komplementärmasken eine Registriermaske 25 für die Chipregistrierung. Der in Fig. 2 gestrichelt dargestellte Kreis 26 entspricht dem Durchmesser des zur Belichtung verwendeten Elektronenstrahls; er beträgt ungefähr 1 mm.

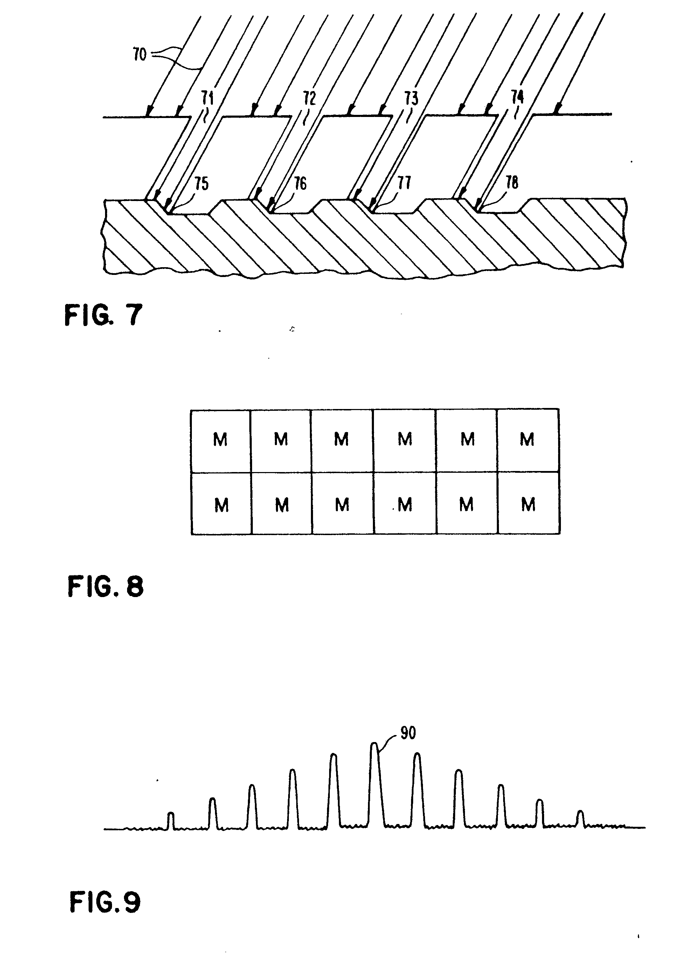

Auf der Waferoberfläche sind (außerhalb der Bereiche, in denen Schaltkreise definiert werden sollen) Registriermarken angebracht, deren Struktur den Richt-Masken entspricht. Diese Marken können z. B. als Kanten ausgebildet sein (entsprechend der Darstellung in Fig. 7 bei Bezugszeichen 75—78), oder aber aus entsprechenden Metall-Mustern bestehen.

Die Registriermaske 25 muß so angeordnet sein, daß der Elektronenstrahl beim Registrieren nicht in den Chipbereich gelangt. Da der Abstand zwischen den beiden Komplementärmasken bei 0,2 mm liegt, kann die Registriermaske nicht in diesem Zwischenraum angeordnet werden. Zweckmäßig wird die Breite der Registriermaske 25 etwas geringer als der Abstnad der Komplementärmasken gewählt, ihre Länge entspricht dem Durchmesser des Elektronenstrahls.

Die Registriermaske 22 für die Waferregistrierung entspricht in ihrer Größe (~1 × 1 mm) ungefähr dem Strahldurchmesser.

Nach der für jeden Chipbereich separat durchgeführten Feinjustierung wird der Elektronenstrahl rasterförmig über die Chipmasken geführt, um diese homogen auszuleuchten. Der Kippwinkel des Strahls bei der Belichtung entspricht dem bei der Feinjustierung ermittelten.

Bei dieser gegenseitigen Lage von Belichtungs- und Registriermasken braucht der Durchmesser des Elektronenstrahls also zu keinem Zeitpunkt verändert werden.

Die Registriermasken 22 und 25 in Fig. 2 weisen in zwei zueinander senkrecht liegenden Richtungen jeweils eine Vielzahl von Öffnungen auf. Eine einfache Anordnung einer Registriermaske 30 zeigt Fig. 3 mit jeweils gleichen Abständen zwischen den einzelnen Öffnungen. Diese Maske dient nur zur Erhöhung des Signal/Rauschverhältnisses bei Elektronenstrahlbelichtungseinrichtungen mit geringer Stromdichte. Hier, wie auch in den folgenden Beispielen, enthält der Wafer eine Registriermarkenstruktur, die im wesentlichen gleich der Lochstruktur der jeweiligen Registriermaske ist. Die Dimensionen der Registriermarken auf dem Wafer sind im allgemeinen aber ein wenig größer als die Dimensionen der Teilstrahlen, die beim Durchgang des Elektronenstrahls durch die Richtmaske entstehen, um ein möglichst gutes Registriersignal zu erhalten. Die den Registriermasken entsprechenden Registriermarken auf dem Wafer werden zweckmäßig auf die Schnittzonen gelegt, längs denen der Wafer in einzelne Chips zersägt wird. Zur Registrierung wird der Wafer relativ zur Maske so lange verschoben, bis das Markenmuster des Wafers optimal unter dem Lochmuster der Maske liegt, was durch ein maximales Registriersignal (Zahl der absorbierten Elektronen) erkannt wird.

Bei einer einfachen quadratischen oder rechteckigen Matrix wie in Fig. 3 besteht infolge der Symmetrie des Musters keine Eindeutigkeit zwischen Registriersignal und Relativ-Lage. Diese Eindeutigkeit wird durch eine Lochanordnung wie in Fig. 4 erzwungen. Die einzelnen Löcher 41 der Maske 40 bzw. die entsprechenden Marken auf dem Wafer sind dazu in ungleichen Abständen angeordnet. Das Bildungsgesetz (Gl. 2) für die Lochanordnungen mit Eindeutigkeit der Registrierung ist im folgenden abgeleitet.

Die Mittelpunktabstände $d_\mu$ (Fig. 4) zweier beliebiger Löcher in einer Reihe und/oder Spalte sind alle verschieden voneinander und lassen sich darstellen als das ganzzahlige Vielfache einer Größe $d_0$, die größer ist als die Breite einer Registriermarke $l_0$:

$$d_0 = l_0 + \Delta \qquad (1)$$

Der Betrag von $\Delta(\geq 0)$ hängt davon ab, ob das Registriersignal überwiegend durch Streuung der Elektronen an der Kante der Registriermarke erzeugt wird, die aus demselben Material wie das Substrat besteht (Reliefkontrast) oder durch erhöhte Reflexion an einem speziellen Markenmaterial (Materialkontrast). In letzterem Fall kann $\Delta$ ungefähr 0 gewählt werden.

Die Mittelpunktabstände zweier beliebiger Löcher ergeben sich aus:

$$d_\mu = n_\mu \cdot d_0$$
mit
$$n_\mu \in \{2, 3, 4, \ldots\} \qquad (2)$$

mit folgender Einschränkung:

Aus der Menge der möglichen Lochabstände d sind nur die zugelassen, die nicht als Summe anderer Abstände darstellbar sind, d. h., es muß gelten

$$n_\mu \neq \sum_{\nu=1}^{\mu-1} \rho_\nu n_\nu \quad \text{mit} \quad \rho_\nu \in \{0; 1\}. \qquad (3)$$

Nach diesem Bildungsgesetz sind viele Abstandsanordnungen möglich. Beispiele für $d_0=1$ in willkürlichen Einheiten sind:

2, 3, 4, 8, 16 (siehe Fig. 4 mit $\Delta=0$)
oder
2, 4, 5, 8, 16
oder
2, 3, 6, 7, 14 usw.

sowie die gespiegelten Anordnungen.

Bei allen diesen Anordnungen ist das maximale Signal, das die Übereinstimmung von Maskenlöchern und Wafermarken anzeigt, um den Faktor K höher als das Grundsignal, wenn jeweils eine Öffnung der Maske und eine Marke des Wafers genau übereinander stehen. K ist dabei die Anzahl der Öffnungen nach obiger Bildungsvorschrift.

Der Wert des gesamten Registrierstroms, der mit einer Vielfachmaske nach Fig. 4 erreicht wird, kann folgendermaßen abgeschätzt werden:

Registriermarkenfläche: $\qquad S_R = 0,2 \cdot 1 \text{ mm}^2$

Querschnitt des Elektronenstrahls:

$$S_{EB} = \pi \left(\frac{1}{2}\right)^2 \text{ mm}^2$$

Transparenz des Maskenausschnitts (Lochfläche/Gesamtfläche): $T = 0,13$
Strahlstrom in Querschnitt $F_{EB}$: $i_{EB} = 60\ \mu A$

Registrierstrom:

$$i_R = T \frac{F_R}{F_{EB}} \cdot i_{EB} = 2,0\ \mu A.$$

Dieser Strom entspricht ungefähr dem von Rasterverfahren, obwohl hier die Stromdichte des Elektronenstrahls sehr viel geringer ist. Das Signal/Rauschverhältnis der Registriersignale hat daher in beiden Fällen auch vergleichbare Werte, da dieses im wesentlichen vom Gesamtstrom bestimmt wird: Der Rauschanteil von Primärstrom und reflektiertem Strom steigt nämlich nur proportional zur Wurzel des Gesamtstroms. Aufgrund des hohen Signal/Rauschverhältnisses sind auch kurze Registrierzeiten möglich.

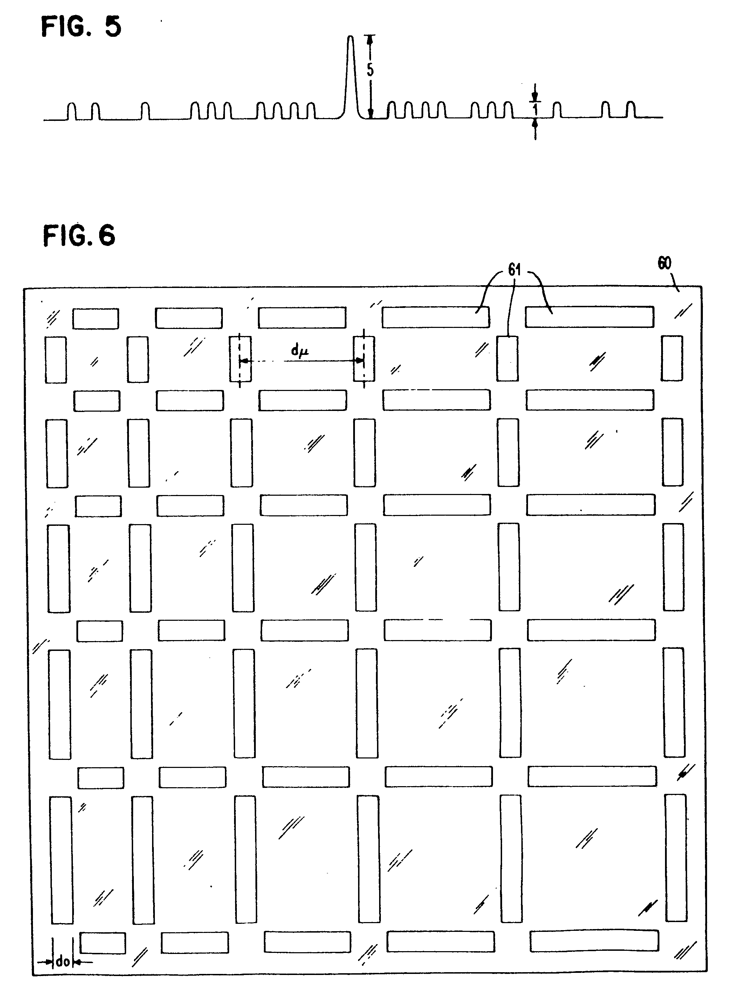

Eine Registriermaske, die nach dem obigen Bildungsgesetz aufgebaut ist, läßt auch erkennen, in welcher Richtung der Wafer zum Einstellen der Sollage bewegt werden muß. In Fig. 5 ist die Folge von Signalen wiedergegeben, die bei der Verschiebung der Maske entsteht. Solange die Registrierung noch nicht optimal ist, ergeben sich Signale in einer für die jeweilige Maske charakteristischen Folge, die bezüglich des Signals bei der Sollage symmetrisch ist. Bei der Maske nach Fig. 4 mit $K = 5$ Öffnungen pro Zeile und Spalte ist das Sollsignal 5mal höher als das Grundsignal. Die Lochfolgen in x- und y-Richtung bei zweidimensionaler Registrierung können auch verschieden sein und ergeben entsprechend verschiedene Signalfolgen. Ein Ausschnitt 42 der Maske 40 kann z. B. als rechteckige Maske für die Chipregistrierung dienen (wie bei Bezugszeichen 25 in Fig. 2).

Die in Fig. 4 dargestellte Maske mit quadratischen Öffnungen und einer relativ geringen Transparenz von $T = 0,13$ hat den Nachteil, daß bei stark dejustierter Anfangslage nur eine sehr geringe Überdeckung zwischen Maskenöffnungen und Registriermarken vorliegt. Das Registriersignal ist dann sehr gering und reicht in ungünstigen Fällen für den Registriervorgang nicht aus. Mit einer Maskenstruktur nach Fig. 6 tritt dieser Nachteil nicht auf. Anstelle der quadratischen Öffnungen sind dort rechteckige Öffnungen (61) verwendet, deren Mittelpunktsabstände nach dem gleichen Bildungsgesetz wie im Fall der Fig. 4 gewählt werden. Die Maskenöffnungen schließen somit in x- und y-Richtung flächenmäßig größer werdende Quadrate oder Rechtecke ein. Die Transparenz der Maske 60 erhöht sich dadurch auf den Wert $T = 0,2$ und es ist sichergestellt, daß auch bei stark gegeneinander verschobener Lage von Maske und Wafer ein genügend starkes Registriersignal auftritt. Die Signalfolge bei der Registrierung entspricht dabei im wesentlichen der in Fig. 5 dargestellten. Der maximale Registrierstrom beträgt hier $3\ \mu A$

(statt $2\ \mu A$ im Fall der Fig. 4). Die Abstandsfolge im gewählten Beispiel ist 4; 5, 6, 7, 8.

Die bisher besprochenen Maskenstrukturen nach Fig. 4 oder 6 eignen sich insbesondere für die durch elektronisches Kippen des Strahls erfolgende Registrierung der einzelnen Chipmasken bei festgehaltenem Wafer. Fig. 7 zeigt diesen Vorgang anhand eines senkrecht zur Waferoberfläche gelegten Schnittes; der durch die Registriermaske aufgespaltene Strahl 70 mit den Teilstrahlen 71, 72, 73, 74 wird gekippt, bis das an in den Wafer geätzten Registriermarken (Kanten) 75, 76, 77, 78 entstehende Registriersignal den maximalen Wert aufweist. Mit der so ermittelten Strahlneigung wird anschließend der Elektronenstrahl über die Belichtungsmasken für das betreffende Chip geführt und zwar zeilenweise so, daß sich eine homogene Beleuchtung ergibt. Wie schon erwähnt, beträgt der nutzbare Registrierbereich bei diesem Verfahren einige $\mu$.

Treten anfangs größere Unterschiede zwischen Maske und Wafer auf, insbesondere bei der mechanisch-interferometrischen Waferregistrierung (mit einem Justierbereich von etwa 0,5 mm), so wird eine Maske mit einer Struktur nach Fig. 8 verwendet. Diese besteht aus einer Vielzahl von Teilmasken M, die jeweils eine Struktur nach Fig. 4 oder 6 aufweisen. Diese Vielfachmaske erzeugt ein Registriersignal, wie es in Fig. 9 dargestellt ist. Das der Sollposition entsprechende Signal 90 hat den Maximalwert, die Amplituden der Nebenmaxima wachsen mit Annäherung an die Sollposition. Die Bestimmung der Bewegungsrichtung, die zur Sollposition führt, kann daher leichter bestimmt werden, als mit Einfachmasken der früher besprochenen Art.

Wenn zur Verkürzung der Registrierzeit statt der absorbierten Elektronen die reflektierten herangezogen werden sollen, kann dies mit Detektoranordnungen erfolgen, die in den Fig. 10 und 11 dargestellt sind. Es handelt sich um Halbleiterdetektoren (mit pn-Grenzschichten), die als Bestandteil der Belichtungsmaske um die Registriermasken angeordnet sind.

In den Fig. 10A und B ist die aus Fig. 2 bekannte Belichtungsmaske dargestellt (unter Beibehaltung der dort verwendeten Bezugszeichen), wobei zusätzliche Anordnungen von Detektoren jeweils um die Wafer- und Chip-Registriermasken vorgesehen sind. In Fig. 10A sind die Registriermasken 22 und 25 jeweils halbkreisförmig von fünf Detektoren 27a—e und 28a—e umgeben, die für reflektierte Elektronen empfindlich sind. Die halbkreisförmige Anordnung der relativ großflächigen Detektoren wird gewählt, um den von den Detektoren aufgespannten Raumwinkel und damit die Anzahl der erfaßten rückgestreuten Elektronen möglichst groß zu machen.

In Fig. 10B sind um jede der beiden Registriermasken 22, 25 drei U-förmige Anordnungen 33, 34, 35 bzw. 33', 34', 35' von einzelnen Detektoren (jeweils mit a, b, c ... bezeichnet) dargestellt. Mit derartigen Anordnungen und geeignet gewählter elektrischer Zusammenschaltung der Detektoren läßt sich eine »Richtungs-Diskriminierung« der reflektierten Elektronen erreichen, d. h. es kann festgestellt werden, in welcher Richtung die Elektronen reflektiert werden. Die Form der einzelnen Anordnungen, deren Abstände voneinander und von den Registriermasken sowie die Zahl der jeweils verwendeten Detektoren kann dabei variiert werden. Die Anordnungen 33, 34 und 35 in Fig. 10B könnten beispielsweise auch als Halbkreise ausgebildet werden, um durch Koinzidenz entsprechender Detektoren festzustellen, in welcher Richtung die reflektierten Elektronen verlaufen (diese Richtungsfeststellung ist mit einer U-förmigen Anordnung nicht mit derselben Präzision erreichbar).

Die präzise Feststellung der Reflektionsrichtung von Elektronen ist insbesondere für solche Richtmarken auf dem Substrat von Interesse, die als V-förmige Vertiefungen ausgebildet sind.

Möglichkeiten zur Ausgestaltung der einzelnen Detektoren in den Anordnungen 27, 28, 33 bis 35 sind in den Teilfiguren A und B von Fig. 11 dargestellt. In beiden Fällen wird als Belichtungsmaske 21 eine relativ dicke Siliciumscheibe verwendet, die abgeböschte Vertiefungen (z. B. 104 in Fig. 11A) enthält, in denen das Belichtungsmuster (z. B. Registriermuster 22) als Lochmuster in einem sehr dünnen Teil der Siliciumscheibe 21 ausgebildet ist. Nähere Einzelheiten über Struktur und Herstellung derartiger Lochmasken für Elektronenstrahllithographie sind in der deutsche Patentanmeldung P 2 922 416.6 beschrieben.

Da wegen des früher erwähnten sehr geringen Abstands zwischen Maske 7 und Substrat 8 in Fig. 1 kein Platz zur Anordnung üblicher Teilchendetektoren bleibt, müssen diese als bauliche Einheit mit der Belichtungsmaske 21 ausgebildet werden. Zwischen den Detektoren und der Oberfläche der Belichtungsmaske darf kein Abstand entstehen, da sonst von der Maskenoberfläche reflektierte Elektronen in die Detektoren gelangen können und so das Richtsignal verfälschen.

In Fig. 11A ist eine erste Ausführungsform derartiger mit der Belichtungsmaske 21 verbundener Detektoren dargestellt, bei der die Detektoren 100a, b als Einzelelemente auf entsprechende Durchbrüche 105a, 105b der Siliciumscheibe aufgesetzt werden. Die Durchbrüche entsprechen in ihrer Form den Aussparungen 104 der Gebiete mit Maskenstrukturen und können im gleichen Herstellungsgang erzeugt werden. Die pn-Grenzschichten der Detektoren sind mit den Bezugszeichen 102a, b symbolisch dargestellt, die Kontaktanschlüsse der Detektoren (die auch als integrierte Leitungsbahnen auf der Oberfläche der Maske ausgebildet sein können) mit den Bezugszeichen 101a, b.

In Fig. 11A ist die Belichtungsmaske 21 in einer Lage dargestellt, die dem Schnitt A, B von Fig. 10A entspricht. Beim Registriervorgang fällt das Elektronenstrahlbündel 2 durch die Registriermaske 22, wird dort in Teilbündel aufgespalten, die an entsprechenden Richtmarken 106 an der Oberfläche des Substrats 8 reflektiert werden und als Reflektionsbündel 103a, 103b zu den Detektoren 100a, 100b gelangen.

Eine weitere Ausführungsform der Elektronendetektoren ist in Fig. 11B dargestellt. Der Detektor ist dort als integrierter Bestandteil der Siliciumscheibe der Belichtungsmaske 21 ausgebildet. Zur Herstellung des Detektors wird die Siliciumscheibe 21 entsprechend der gewünschten Detektorfläche bis auf eine dünne Restscheibe 110 trogförmig ausgedünnt; dieses Vorgehen entspricht dem ersten Herstellschritt für die Bereiche, in denen Lochmuster definiert werden sollen. Die Schicht 110 ist entsprechend einem p-Gebiet dotiert; aus ihr wird mit Epitaxie eine n-Siliciumschicht 111 aufgebracht, die wiederum von einer Metallelektrode 112 mit Kontaktanschluß 114 bedeckt wird. Die Ränder des Elektronendetektors werden duch eine Ringisolation 113a, 113b definiert, die beispielsweise aus Quarz besteht und durch die p-dotierte Schicht der Siliciumscheibe 21 hindurchreicht.

Diese integrierte Anordnung von Elektronendetektoren läßt sich mit den in der Halbleiterfertigung üblichen Methoden der Photolithographie herstellen, so daß auch komplizierte Detektoranordnungen, wie beispielsweise nach Fig. 10B, ohne großen Aufwand erreichbar sind. Aufgrund der kleinen beteiligten RC-Konstanten läßt sich mit derartigen Detektoranodnungen eine kurze Gesamtregistrierzeit erreichen, obwohl das Signal der reflektierten Elektronen stärker verrauscht ist als bei absorbierten Elektronen.

## Patentansprüche

1. Projektionssystem für Korpuskularstrahlen, insbesondere Elektronenstrahlen, zur Belichtung eines Substrats (Wafer 8) durch eine Maske (7) mit einem als Richtmaske ausgebildeten Teil (22, 25), der zur Erzeugung von Richtsignalen für die Registrierung von Maske und Substrat auf Richtmarken (75—78) des Substrats abgebildet wird, dadurch gekennzeichnet,

— daß die Richtmaske aus einer matrixförmigen Anordnung von für Korpuskularstrahlen durchlässigen Öffnungen (31) besteht,
— daß der zur Belichtung verwendete Korpuskularstrahl zur Registrierung auf die Richtmaske (22, 25) abgelenkt wird, wobei er die Richtmaske in ihrer Gesamtheit beaufschlagt und dabei in eine den Öffnungen (31) der Richtmaske entsprechende matrixförmige Anordnung von Teilstrahlen (71—74) aufgespalten wird,
— und daß die Teilstrahlen auf Richtmarken (75—78) des Substrats projiziert werden, deren Anordnung der Struktur der Richtmaske entspricht.

2. Projektionssystem nach Anspruch 1, dadurch gekennzeichnet, daß der Elektronenstrahl bei der Registrierung lediglich abgelenkt, aber in seinem Fokussierungszustand unverändert ist.

3. Projektionssystem nach Anspruch 1 oder 2, dadurch gekennzeichnet, daß die Mittelpunktabstände ($d_\mu$) der Öffnungen (41) in der Richtmaske bei Fortschreiten in zwei zueinander senkrechten Richtungen so anwachsen, daß kein Abstand durch die Summe kleinerer Abstände darstellbar ist (Gleichung 2).

4. Projektionssystem nach einem der Ansprüche 1 bis 3, daduch gekennzeichnet, daß die Öffnungen der Richtmaske (41) quadratisch gestaltet sind.

5. Richtmaske nach einem der Ansprüche 1 bis 3, dadurch gekennzeichnet, daß die Öffnungen (61) der Richtmaske Rechtecke sind, deren lange in Fortschrittsrichtung liegende Seite entsprechend dem zunehmenden Mittelpunktsabstand der dazu senkrecht liegenden Rechtecke zunimmt (Fig. 6).

6. Projektionssystem nach einem der Ansprüche 1 bis 5, dadurch gekennzeichnet, daß die Richtmaske aus mehreren Einzelmasken matrixförmig angeordneter Öffnungen besteht (Fig. 8).

7. Projektionssystem nach einem der Ansprüche 1 bis 6, dadurch gekennzeichnet, daß die Belichtungsmaske eine Richtmaske (22) zur Registrierung des Substrats im ganzen (Waferregistrierung) enthält, sowie eine Richtmaske oder eine Vielzahl davon (25), die den einzelnen, sich wiederholenden Mustern (Chipmuster) der Belichtungsmaske zugeordnet sind und deren Feinjustierung (Chipregistrierung) dienen.

8. Projektionssystem nach Anspruch 7, dadurch gekennzeichnet, daß die Richtmaske (22) für die Waferregistrierung ungefähr die Größe des belichteten Elektronenstrahls (Durchmesser ~1 mm) aufweist und so an der Peripherie der Belichtungsmaske angeordnet ist, daß die Registrierung ohne gleichzeitige Belichtung der Chipbereiche erfolgt.

9. Projektionssystem nach Anspruch 7 oder 8, dadurch gekennzeichnet, daß die Richtmuster für die Chipregistrierung so an der Peripherie der einzelnen Chipbereiche angeordnet sind, daß die Registrierung ohne Belichtung der Chipbereiche erfolgt.

10. Projektionssystem nach einem der Ansprüche 7 bis 9, dadurch gekennzeichnet, daß die den Richtmarken (22, 25) entsprechenden Richtmarken auf dem Substrat an den Stellen angebracht sind, durch die Trennlinien bei der Zerlegung des Substrats nach Fertigstellung in einzelne Chips verlaufen.

11. Projektionssystem nach Anspruch 10, daduch gekennzeichnet, daß die Richtmasken (25) für Chipregistrierung die Form eines Rechtecks haben, dessen lange Seite dem Durchmesser des Elektronenstrahls entspricht und dessen kurze Seite entsprechend der Breite der Schnittlinien für die Substrattrennung gewählt ist.

12. Projektionssystem nach einem der Ansprüche 7 bis 11, dadurch gekennzeichnet, daß die Waferregistrierung mit mechanischen Mitteln erfolgt und die Chipregistrierung durch individuelle, elektronisch gesteuerte Kippung des Elektronenstrahls.

13. Projektionssystem nach einem der Ansprüche 1 bis 12, dadurch gekennzeichnet, daß das Richtsignal durch Messung der an den Richtmarken absorbierten Elektronen der Teilbündel (71—74) gewonnen wird.

14. Projektionssystem nach einem der Ansprüche 1 bis 12, dadurch gekennzeichnet, daß das Richtsignal durch Messung der an den Richtmarken reflektierten Elektronen der Teilbündel gewonnen wird und daß in der Belichtungsmaske (21) Teilchendetektoren (27, 28, 33—35) angebracht sind, die auf Elektronen ansprechen.

15. Projektionssystem nach Anspruch 14, dadurch gekennzeichnet, daß jede Registriermaske (22, 25) von mehreren Teilchendetektoren umgeben ist.

16. Projektionssystem nach Anspruch 15, dadurch gekennzeichnet, daß jede Registriermaske (22, 25) von einem oder mehreren, im wesentlichen halbkreisförmig angeordneten, Mehrheiten von Teilchendetektoren umgeben ist.

17. Projektionssystem nach einem der Ansprüche 14 bis 16, dadurch gekennzeichnet, daß die Teilchendetektoren (100) auf Löcher (105) der Belichtungsmaske (21) aufgesetzt sind.

18. Projektionssystem nach einem der Ansprüche 14 bis 16, dadurch gekennzeichnet, daß die Belichtungsmaske (21) aus Silicium besteht und daß die Teilchendetektoren integrierte Bestandteile dieser Siliciumscheibe sind.

19. Projektionssystem nach Anspruch 18, dadurch gekennzeichnet, daß die Siliciumscheibe (21) an der Stelle eines Teilchendetektors bis auf eine dünne Oberflächenschicht (110) ausgedünnt ist, deren Leitfähigkeitstyp sich vom Rest der Siliciumscheibe unterscheidet, daß auf dieser Oberflächenschicht eine Siliciumschicht (11) entgegengesetzten Leitfähigkeitstyps epitaktisch aufgebracht ist und daß auf der Epitaxieschicht eine Metallelektrode (112) mit Kontaktanschluß (114) angebracht ist.

## Claims

1. Projection system for corpuscular beams, particularly electron beams, for exposing a substrate (wafer 8) throug a mask (7), with a part (22, 25) designed as an alignment mask which for producing alignment signals for the registration of mask and substrate is imaged on alignment marks (75—78) of the substrate, characterized in

- that the alignment mask consists of a matrix-shaped arrangement of openings (31) transparent for corpuscular beams,
- that the corpuscular beam used for exposure is deflected for regisration to the alignment mask (22, 25), covering the entire alignment mask and being divided in the process into a matrix-like arrangement of partial beams (71—74) corresponding to the openings (31) of the alignment mask,

— and that the partial beams are projected onto alignment marks (75—78) of the substrate whose arrangement corresponds to the structure of the alignment mask.

2. Projection system as claimed in claim 1, characterized in that upon registration the electron beam is merely deflected but remains unchanged in its focussing state.

3. Projection system as claimed in claim 1 or 2, characterized in that the center spacings $(d\mu)$ of the openings (41) in the alignment mask increase upon advance in two directions perpendicular to each other in such a way that no distance can be represented by the sum of smaller distances (equation 2).

4. Projection system as claimed in one of claims 1 to 3, characterized in that the openings of the alignment mask (41) are square.

5. Projection system as claimed in one of claims 1 to 3, characterized in that the openings (61) of the alignment mask are rectangles whose long side extending in advance direction increases in accordance with the increasing center spacing of the rectangles provided vertically thereto (fig. 6).

6. Projection system as claimed in one of claims 1 to 5, characterized in that the alignment mask consists of several individual masks having openings arranged in matrix-fashion (fig. 8).

7. Projection system as claimed in one of claims 1 to 6, characterized in that the exposure mask comprises an alignment mask (22) for the registration of the substrate as a whole (wafer registration), as well as an alignment mask or a multitude thereof (25) associated to the individual repeated patterns (chip patterns) of the exposure mask, and serving for their precision adjustment (chip registration).

8. Projection system as claimed in claim 7, characterized in that the alignment mask (22) for wafer registration has approximately the size of the exposing electron beam (diameter ~1 mm), and that it is arranged at the periphery of the exposure mask in such a manner that the registration takes place without the simultaneous exposure of the chip areas.

9. Projection system as claimed in claim 7 or 8, characterized in that the alignment patterns for chip registration are arranged at the periphery of the individual chip areas in such a manner that registration takes place without exposure of the chip areas.

10. Projection system as claimed in one of claims 7 to 9, characterized in that the alignment marks corresponding to the alignment masks (22, 25) are provided on the substrate in spots through which pass the kerfs for cutting the substrate into individual chips after manufacture.

11. Projection system as claimed in claim 10, characterized in that the alignment masks (25) for chip registration show the form of a rectangle whose long side corresponds to the diameter of the electron beam, and whose short side is selected in accordance with the width of the kerfs for substrate cutting.

12. Projection system as claimed in one of claim 7 to 11, characterized in that wafer registration takes place mechanically, and chip registration through the individual electronically controlled tilting of the electron beam.

13. Projection system as claimed in one of claim 1 to 12, characterized in that the alignment signal is obtained through the measuring of the electrons of the partial beams (71—74) absorbed at the alignment marks.

14. Projection system as claimed in one of claims 1 to 12, characterized in that the alignment signal is obtained through measuring the partial beam electrons reflected from the alignment marks, and that in the exposure mask (21) particle detectors (27, 28, 33—35) are provided that respond to electrons.

15. Projection system as claimed in claim 14, characterized in that each registration mask (22, 25) is surrounded by several particle detectors.

16. Projection system as claimed in claim 15, characterized in that each registration mask (22, 25) is surrounded by one or several pluralities of particle detectors substantially arranged in a semi-circle.

17. Projection system as claimed in one of claims 14 to 16, characterized in that the particle detectors (100) are placed on holes (105) of the exposure mask (21).

18. Projection system as claimed in one of claims 14 to 16, characterized in that the exposure mask (21) consists of silicon, and that the particle detectors are integrated components of this silicon wafer.

19. Projection system as claimed in claim 18, characterized in that the silicon wafer (21), at the position of a particle detector, is thinned out down to a thin surface layer (110) whose conductivity differs from the rest of the silicon wafer, that on this surface layer a silicon layer (11) of opposite conductivity is epitaxially provided, and that on the epitaxial layer a metal electrode (112) with contact (114) is provided.

**Revendications**

1. Système de projection à faisceaux d'éléments corpusculaires, en particulier de faisceaux électroniques, permettant d'exposer un substrat (tranche 8) à travers un masque (7) comportant une partie (22, 25) conçue comme masque d'alignement, laquelle partie est reproduite sur des marques d'alignement (75—78) dudit substrat afin de générer des signaux d'alignement permettant l'alignement du masque et du substrat, caractérisé en ce que:

— ledit masque d'alignement est composé d'un arrangement matriciel d'ouvertures (31) pour le passage des faisceaux corpusculaires,

— que le faisceau corpusculaire utilisé par l'ex-

position est dévié afin de l'aligner sur ledit masque d'alignement (22, 25) où il couvre l'ensemble dudit masque d'alignement et où il est divisé en un arrangement matriciel de faisceaux partiels (71—74) et correspondant aux ouvertures (31) dudit masque d'alignement,

— lesdits faisceaux partiels sont projetés sur lesdites marques d'alignement (75—78) dudit substrat dont l'arrangement correspond à la configuration du masque d'alignement.

2. Système de projection selon la revendication 1, caractérisé en ce que le faisceau électronique est dévié uniquement lors de l'alignement mais que ses conditions de concentration ne sont pas modifiées.

3. Système de projection selon une des revendications 1 ou 2, caractérisé en ce que les écarts des centres (dµ) des ouvertures (41) pratiquées dans ladit masque d'alignement augmentent progressivement dans deux directions perpendiculaires l'une par rapport à l'autre de telle sorte qu'aucun de ces écarts ne peut etre représenté par la somme d'écarts plus petits (équation 2).

4. Système de projection selon une des revendications 1 à 3, caractérisé en ce que lesdites ouvertures dans ledit masque d'alignement (41) ont une forme de carré.

5. Système de projection selon une des revendications 1 à 3, caractérisé en ce que lesdites ouvertures (61) dans ledit masque d'alignement ont une forme de rectangle dont le coté le plus long s'étendant dans la direction de la progression augmente proportionnellement à l'accroissement de l'écart des centres des rectangles qui lui sont perpendiculaires (figure 6).

6. Système de projection selon une des revendications 1 à 5, caractérisé en ce que ledit masque d'alignement est composé de plusieurs masques individuels comportant des ouvertures disposées selon une matrice (figure 8).

7. Système de projection selon une des revendications 1 à 6, caractérisé en ce que le masque pour l'exposition contient un masque d'alignement (22) destiné à aligner l'ensemble dudit substrat (alignement de la tranche), et aussi un masque ou grand nombre de masques d'alignement (25) correspondant aux nombreux motifs répétés (configurations de puce) dudit masque pour l'exposition et servant à les ajuster de façon précise (alignement de la puce).

8. Système de projection selon la revendication 7, les dimensions dudit masque d'alignement (22) destiné à l'alignement de ladite tranche équivalent approximativement celles du faisceau électronique (diamètre 1 mm) et que ledit masque d'alignement est disposé dans la périphérie dudit masque d'exposition de telle sorte que l'alignement se produit sans impliquer l'exposition simultanée des régions formant des puces dans la tranche.

9. Système de projection selon la revendication 7 ou 8, caractérisé en ce que les configurations d'alignement destinées à l'alignement des puces sont disposées à la périphérie des différentes régions formant les puces de telle sorte que l'alignement n'implique pas l'exposition desdites régions.

10. Système de projection selon une des revendications 7 à 9, caractérisé en ce que les marques d'alignement correspondants auxdits masques d'alignement (22, 25) sont imprimées sur ledit substrat aux endroits dans lesquels passent des lignes de délimitation pour la découpe dudit substrat, une fois les différentes puces réalisées.

11. Système de projection selon la revendication 10, caractérisé en ce que lesdits masques d'alignement (25) destinés à l'alignement des puces ont une forme de rectangle dont le coté de plus long correspond au diamètre dudit faisceau électronique et dont le coté le plus court est choisi en fonction de la largeur des lignes servant à la découpe dudit substrat.

12. Système de projection selon une des revendication 7 à 11, caractérisé en ce que l'alignement de la tranche est effectué à l'aide de moyens mécaniques et l'alignement des circuits est effectué par des déviations particulières dudit faisceau qui sont commandées électroniquement.

13. Système de projection selon une des revendication 1 à 12, caractérisé en ce que ledit signal d'alignement est issu de la mesure des électrons des faisceaux partiels (71—74) qui sont absorbés auxdites marques d'alignement.

14. Système de projection selon une des revendications 1 à 12, caractérisé en ce que ledit signal d'alignement est issu de la mesure des électrons desdits faisceaux partiels qui sont réfléchis sur lesdites marques d'alignement et, qu'il est prévu dans ledit masque d'exposition (21) des détecteurs de particules (27, 28, 33—35) sensibles aux électrons.

15. Système de projection selon la revendication 14, caractérisé en ce que chaque masque d'alignement (22, 25) est entouré par plusieurs détecteurs de particules.

16. Système de projection selon la revendication 15, caractérisé en ce que chaque masque d'alignement (22, 25) est entouré par un ou plusieurs groupes de détecteurs de particules, généralement disposés de façon semi-circulaire.

17. Système de projection selon one des revendications 14 à 16, caractérisé en ce que lesdits détecteurs de particules (100) sont disposés sur des trous (105) dans ledit masque d'exposition (21).

18. Système de projection selon une des revendications 14 à 16, caractérisé en ce que ledit masque d'exposition (21) est en silicium et que les détecteurs de particules sont des composants intégrés de la tranche de silicium.

19. Système de projection selon la revendication 18, caractérisé en ce que ladite tranche de silicium (21) est amincie à l'emplacement du détecteur de particules pour former une couche de surface mince (110) présentant un type de conductivité différent de celui du reste de la tranche de silicium, et ce qu'une couche de silicium (11) du type de conductivité opposé est déposée selon un procédé épitaxique sur cette couche de surface et qu'une électrode métallique (112) avec une connexion de contact (114) est déposée sur cette couche épitaxique.

FIG. 1

0 027 497

13

**FIG. 2**

**FIG. 3**

**FIG. 4**

**FIG. 5**

**FIG. 6**

**FIG. 7**

**FIG. 8**

**FIG.9**

**FIG.10 A**

**FIG.10 B**

FIG. 11 A

FIG. 11 B